# EUROPEAN PATENT SPECIFICATION

(11) **EP 3 934 187 B1**
(45) Date of publication and mention of the grant of the patent: **17.04.2024**
(21) Application number: 20183029.6
(22) Date of filing: 30.06.2020
(51) Int. Cl.: H04L 25/49, G08C 19/24

(54) **EVENT-DRIVEN TRANSMISSION METHOD AND DEVICE**
VERFAHREN UND VORRICHTUNG ZUR EREIGNISGESTEUERTEN ÜBERTRAGUNG
PROCÉDÉ ET DISPOSITIF DE TRANSMISSION COMMANDÉE PAR LES ÉVÉNEMENTS

(43) Date of publication of application: 05.01.2022
(73) Proprietor: Stichting IMEC Nederland, 5656 AE Eindhoven (NL)
(72) Inventor: Liu, Yao-Hong, 3001 Leuven (BE)
(74) Representative: Körfer, Thomas

(56) References cited:
- EP-A1- 1 763 189
- US-A- 4 121 050
- US-A1- 2013 230 076
- BOVY A C ET AL: "IR-UWB: An high speed digital receiver for very short range transmissions", RADIO AND WIRELESS SYMPOSIUM, 2008 IEEE, IEEE, PISCATAWAY, NJ, USA, 22 January 2008 (2008-01-22), pages 363-366, XP031237174, ISBN: 978-1-4244-1462-8
- SANDEEP MANJUNATH: "Near-Field Baseband Communication SystemFor Use In Biomedical Implants", INTERNET CITATION, 1 June 2009 (2009-06-01), XP002762279, Retrieved from the Internet: URL:http://theses.gla.ac.uk/1128/1/2009man junathphd.pdf [retrieved on 2016-09-26]
- ZASOWSKI T ET AL: "An energy efficient transmitted-reference scheme for ultra wideband communications", ULTRA WIDEBAND SYSTEMS, 2004. JOINT WITH CONFERENCE ON ULTRAWIDEBAND S YSTEMS AND TECHNOLOGIES. JOINT UWBST & IWUWBS. 2004 INTERNATIONAL WORK SHOP ON KYOTO, JAPAN MAY 18-21, 2004, PISCATAWAY, NJ, USA,IEEE, 18 May 2004 (2004-05-18), pages 146-150, XP010716237, DOI: 10.1109/UWBST.2004.1320953 ISBN: 978-0-7803-8373-9
- DATH GAWTHAM G ET AL: "FPGA Implementation of Physical Layer Data Encoding Schemes", 2018 SECOND INTERNATIONAL CONFERENCE ON INVENTIVE COMMUNICATION AND COMPUTATIONAL TECHNOLOGIES (ICICCT), IEEE, 20 April 2018 (2018-04-20), pages 1137-1140, XP033408973, DOI: 10.1109/ICICCT.2018.8473041 [retrieved on 2018-09-26]

## Description

The invention relates to an event-driven transmission method and an event-driven transmission device.

Generally, in times of an increasing number of event-based applications such as sensing applications, there is a growing need of an event-driven transmission method and an event-driven transmission device in order to allow for a transmission or a communication, respectively, in a particularly efficient manner.

For instance, US 9,140,547 B2 relates to a transmission system for a measurement device on a coordinate positioning apparatus comprising a station mounted on the measuring device and another station mounted on the coordinate positioning apparatus, wherein the station and the another station communicate with each other using a spread spectrum radio link, for example, frequency hopping. The station on the probe sends a regular signal and on receiving the signal the another station on the coordinate positioning apparatus synchronizes its clock and sends an acknowledgement signal. Measurement data is either sent in the regular signal or in a measurement event driven signal.

Furthermore, in accordance with said document, the radio signals between the probe and machine stations consist of message packets of serial binary data. Each message contains a header which includes probe station identity data, or address, needed to enable the machine station receiver to recognize whether the message is intended for that receiver and to synchronize a clock in the machine station to the probe station clock. Disadvantageously, especially due to the usage of the header containing identification data, a lot of overhead is introduced, which leads to an inefficient transmission or communication, respectively.

Bovy et al: "IR-UWB: An high speed digital receiver for very short range transmissions", RADIO AND WIRELESS SYMPOSIUM, 2008 IEEE, 22 January 2008, XP031237174 pertains to Digital Pulse Interval Modulation, DPIM, where data is encoded as a number of k discrete time intervals between two adjacent IR-UWB pulses.

Similarly, the thesis by Sandeep Manjunath: "Near-Field Baseband Communication System for Use in Biomedical Implants", 1 June 2009, XP002762279 discloses encoding serial data by a time duration between two subsequent pulses, the first data being encoded with reference to a synchronization pulse indicating the start of a transmission.

EP 1 763 189 A1 pertains to an event-based transmission of pulses, wherein a transmitter ID is encoded as a time interval between multi-pulse packets, additionally to data being encoded in the intra-packet pulse delays.

Zasowski et al: "An energy efficient transmitted-reference scheme for ultra wideband communications", ULTRA WIDEBAND SYSTEMS 2004, IEEE, 18 May 2004, XP010716237 relates to transmitted reference pulse interval and amplitude modulation, TR-PIAM, where bit information is encoded in the amplitude as well as in the delay between subsequent pulses.

US 2013/230076 A1 describes the same type of data encoding, here called Generalized Transmitted Reference, GRT, modulation.

Accordingly, there is an object to provide an event-driven transmission method and an event-driven transmission device in order to allow for a particularly efficient transmission or communication, respectively.

This object is solved by the features of the first independent claim for an event-driven transmission method and the features of the second independent claim for an event-driven transmission device. The dependent claims contain further developments.

According to a first aspect of the invention, an event-driven transmission method according to claim 1 is provided. Said method comprises the steps of converting at least one event to at least one corresponding pulse pair, and transmitting the at least one pulse pair. In this context, a delay between each pulse pair represents a corresponding identifier with respect to the respective event or with respect to at least one corresponding object causing or experiencing the respective event. Advantageously, an overhead and a collision risk can significantly be reduced, which leads to a particularly efficient transmission or communication, respectively. Further advantageously, the at least one event may especially comprise information of polarity, preferably positive and/or negative polarity. It is noted that the at least one event may especially comprise or be a bipolar event. As a further advantage, it is noted that a pulse pair may comprise or be two pulses with the same polarity or two pulses with different polarities.

According to a first preferred implementation form of the first aspect of the invention, the at least one pulse pair comprises or is at least one differential pulse. Advantageously, for instance, complexity can be reduced, thereby increasing efficiency. Further advantageously, a differential pulse may comprise or be two pulses with different polarities.

According to a second preferred implementation form of the first aspect of the invention, for transmitting the at least one pulse pair, the at least one pulse pair is encoded according to a Manchester code, preferably a bipolar Manchester code. Advantageously, for example, low-frequency content of the respective signal can be suppressed, which further increases immunity to the respective communication channel.

According to a further preferred implementation form of the first aspect of the invention, for transmitting the at least one pulse pair, the at least one pulse pair is encoded according to a phase modulation, preferably a differential phase modulation. Advantageously, for instance, the respective receiver can demodulate the corresponding signal especially without recovering the respective carrier frequency and phase.

According to a further preferred implementation form of the first aspect of the invention, the phase modulation comprises rotating between at least two predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees. Advantageously, for example, a higher immunity toward a carrier offset on the respective receiver side can be ensured.

According to a further preferred implementation form of the first aspect of the invention, transmitting the at least one pulse pair is based on an impulse-radio ultra-wideband communication, preferably an asynchronous impulse-radio ultra-wideband communication. Advantageously, for instance, complexity can further be reduced, which leads to an increased efficiency.

According to a further preferred implementation form of the first aspect of the invention, the at least one object comprises or is at least one sensing unit and/or at least one sensor, preferably at least one sensing unit and/or at least one sensor and/or at least one multi-electrode array in the context of neural recording, especially intracortical neural recording. In addition to this or as an alternative, the at least one object comprises or is at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar and/or at least one neuromorphic camera in the context of occupancy sensing especially with respect to smart building applications. Advantageously, for example, a particularly high flexibility can be ensured, thereby further increasing efficiency.

According to a further preferred implementation form of the first aspect of the invention, the at least one event comprises or is a change especially in the context of at least one measurement, preferably a change with respect to the at least one object and/or the environment of the at least one object. Advantageously, for instance, efficiency can further be increased.

According to a second aspect of the invention, an event-driven transmission device according to claim 9 provided. Said device comprises a transmitting unit configured to convert at least one event to at least one corresponding pulse pair and to transmit the at least one pulse pair. In this context, a delay between each pulse pair represents a corresponding identifier with respect to the respective event or with respect to at least one corresponding object causing or experiencing the respective event. Advantageously, an overhead and a collision risk can significantly be reduced, which leads to a particularly efficient transmission or communication, respectively. Further advantageously, the at least one event may especially comprise information of polarity, preferably positive and/or negative polarity. It is noted that the at least one event may especially comprise or be a bipolar event.

According to a first preferred implementation form of the second aspect of the invention, the at least one pulse pair comprises or is at least one differential pulse. Advantageously, for instance, complexity can be reduced, thereby increasing efficiency.

According to a second preferred implementation form of the second aspect of the invention, for transmitting the at least one pulse pair, the transmitting unit is configured to encode the at least one pulse pair according to a Manchester code, preferably a bipolar Manchester code.

Advantageously, for example, low-frequency content of the respective signal can be suppressed, which further increases immunity to the respective communication channel.

According to a further preferred implementation form of the second aspect of the invention, for transmitting the at least one pulse pair, the transmitting unit is configured to encode the at least one pulse pair according to a phase modulation, preferably a differential phase modulation. Advantageously, for instance, the respective receiver can demodulate the corresponding signal especially without recovering the respective carrier frequency and phase.

According to a further preferred implementation form of the second aspect of the invention, the phase modulation comprises rotating between at least two predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees. Advantageously, for example, a higher immunity toward a carrier offset on the respective receiver side can be ensured.

According to a further preferred implementation form of the second aspect of the invention, transmitting the at least one pulse pair is based on an impulse-radio ultra-wideband communication, preferably an asynchronous impulse-radio ultra-wideband communication. Advantageously, for instance, complexity can further be reduced, which leads to an increased efficiency.

According to a further preferred implementation form of the second aspect of the invention, the at least one object comprises or is at least one sensing unit and/or at least one sensor, preferably at least one sensing unit and/or at least one sensor and/or at least one multi-electrode array in the context of neural recording, especially intracortical neural recording. In addition to this or as an alternative, the at least one object comprises or is at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar and/or at least one neuromorphic camera in the context of occupancy sensing especially with respect to smart building applications. Advantageously, for example, a particularly high flexibility can be ensured, thereby further increasing efficiency.

According to a further preferred implementation form of the second aspect of the invention, the at least one event comprises or is a change especially in the context of at least one measurement, preferably a change with respect to the at least one object and/or the environment of the at least one object. Advantageously, for instance, efficiency can further be increased.

Exemplary embodiments of the invention are now further explained with respect to the drawings by way of example only, and not for limitation. In the drawings:
- Fig. 1: shows a flow chart of an exemplary embodiment of the inventive event-driven transmission method;
- Fig. 2: shows an exemplary embodiment of the inventive event-driven transmission device;
- Fig. 3A: shows an exemplary sensor signal being digitized in the context of event encoding;
- Fig. 3B: shows an exemplary embodiment of an asynchronous events transmission from multiple sensors in the context of a wired communication;
- Fig. 3C: shows an exemplary embodiment of an asynchronous events transmission from multiple sensors in the context of a wireless communication;
- Fig. 4: shows an exemplary embodiment of an events transmission from two sensors with respect to a conventional address-event representation;
- Fig. 5A: shows an exemplary embodiment of an inventive time-delay address-event representation;
- Fig. 5B: shows an exemplary embodiment of an inventive transmission device in the context of a wired communication;
- Fig. 5C: shows an exemplary embodiment of a differential phase modulation in accordance with the invention;
- Fig. 5D: shows an exemplary comparison between a conventional address-event representation and an embodiment of the inventive address-event representation;
- Fig. 5E: shows an exemplary embodiment of an inventive transmission device in the context of a wireless communication;
- Fig. 6: shows an exemplary usage scenario with respect to the invention; and
- Fig. 7: shows a further exemplary usage scenario with respect to the invention.

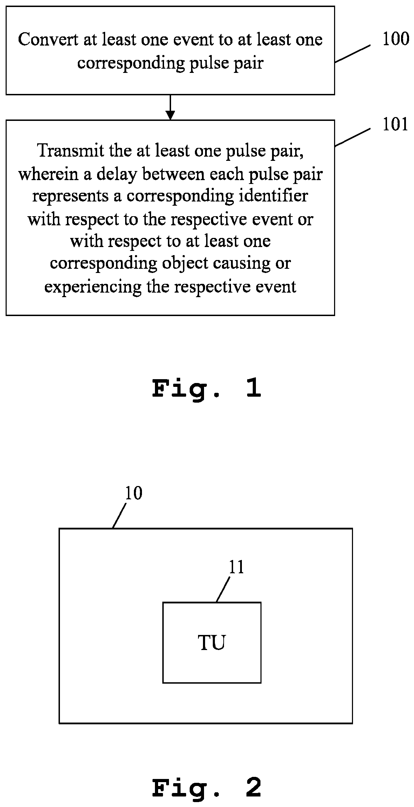

Firstly, Fig. 1 shows a flow chart of an exemplary embodiment of the inventive event-driven transmission method. In a first step 100, at least one event is converted to at least one corresponding pulse pair. Then, in a second step 101, the at least one pulse pair is transmitted. In this context, a delay between each pulse pair represents a corresponding identifier with respect to the respective event or with respect to at least one corresponding object causing or experiencing the respective event.

It is noted that it might be particularly advantageous if the at least one pulse pair comprises or is at least one differential pulse. Furthermore, for transmitting the at least one pulse pair, the at least one pulse pair may be encoded according to a Manchester code, preferably a bipolar Manchester code. Said encoding may especially be used in the case of a wired transmission or communication.

Moreover, for transmitting the at least one pulse pair, the at least one pulse pair may be encoded according to a phase modulation, preferably a differential phase modulation. Said encoding may especially be used in the case of a wireless transmission or communication.

In this context, the phase modulation may especially comprise rotating between at least three predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees. It is further noted that it might be particularly advantageous if transmitting the at least one pulse pair is based on an impulse-radio ultra-wideband (IR-UWB) communication, preferably an asynchronous impulse-radio ultra-wideband communication.

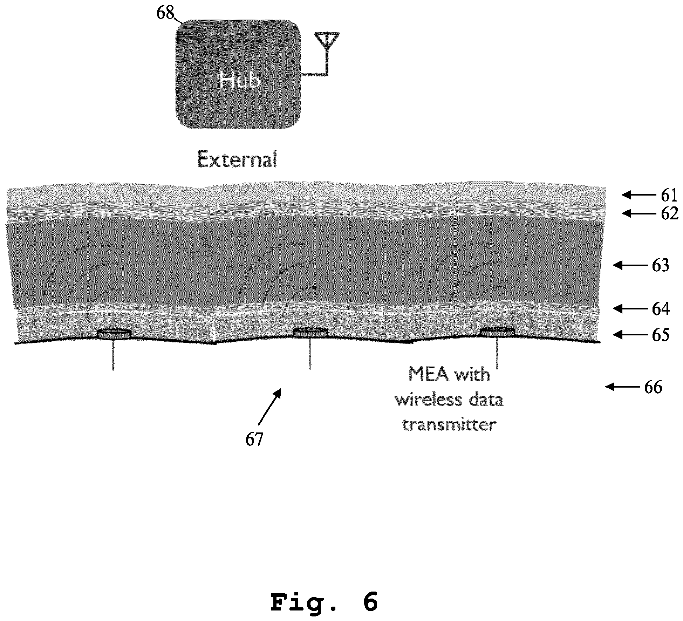

With respect to the at least one object it is noted that the at least one object may comprise or be at least one sensing unit and/or at least one sensor, preferably at least one sensing unit and/or at least one sensor and/or at least one multi-electrode array in the context of neural recording, especially intracortical neural recording, which is exemplarily illustrated by Fig. 6.

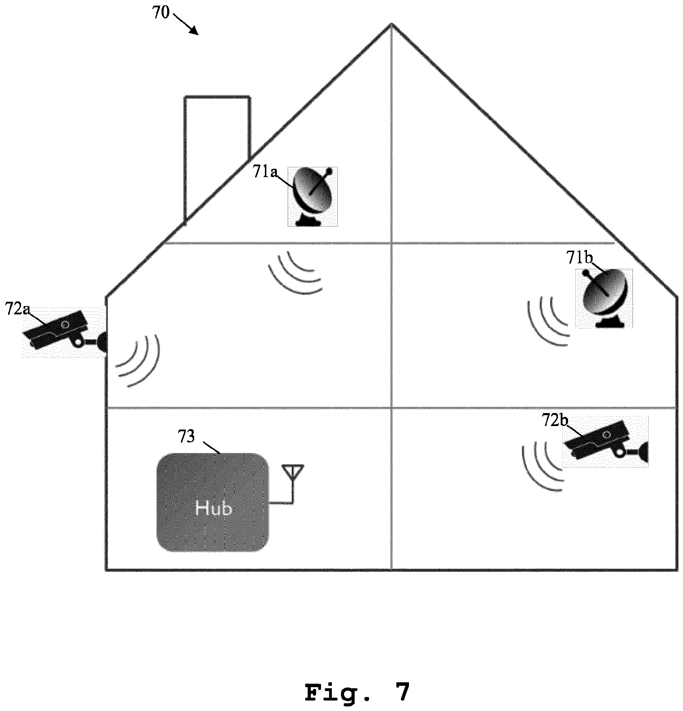

In addition to this or as a alternative, the at least one object may comprise or be at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar and/or at least one neuromorphic camera in the context of occupancy sensing especially with respect to smart building applications, which is exemplarily illustrated by Fig. 7.

With respect to the at least one event, it is noted that the at least one event may comprise or be a change especially in the context of at least one measurement, preferably a change with respect to the at least one object and/or the environment of the at least one object.

Now, with respect to Fig. 2, an exemplary embodiment of the inventive event-driven transmission device 10 is illustrated. Said device 10 comprises a transmitting unit 11 configured to convert at least one event to at least one corresponding pulse pair and to transmit the at least one pulse pair. In this context, a delay between each pulse pair represents a corresponding identifier with respect to the respective event or with respect to at least one corresponding object causing or experiencing the respective event. It is noted that it might be particularly advantageous if the at least one pulse pair comprises or is at least one differential pulse.

It is further noted that for transmitting the at least one pulse pair, the transmitting unit 11 may be configured to encode the at least one pulse pair according to a Manchester code, preferably a bipolar Manchester code. This encoding may especially be applied in the case of a wired transmission or communication, respectively.

Furthermore, for transmitting the at least one pulse pair, the transmitting unit 11 may be configured to encode the at least one pulse pair according to a phase modulation, preferably a differential phase modulation. This encoding may especially be applied in the case of a wireless transmission or communication, respectively.

In this context, the phase modulation may especially comprise rotating between at least three predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees. Moreover, transmitting the at least one pulse pair may especially be based on an impulse-radio ultra-wideband (IR-UWB) communication, preferably an asynchronous impulse-radio ultra-wideband communication.

With respect to the at least one object, it is noted that the at least one object may comprise or be at least one sensing unit and/or at least one sensor, preferably at least one sensing unit and/or at least one sensor and/or at least one multi-electrode array in the context of neural recording, especially intracortical neural recording, which is exemplarily illustrated by Fig. 6 as already noted above.

Additionally or alternatively, the at least one object may comprise or be at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar and/or at least one neuromorphic camera in the context of occupancy sensing especially with respect to smart building applications, which is exemplarily illustrated by Fig. 7 as already noted above.

With respect to the at least one event, it is noted that the at least one event may comprise or be a change especially in the context of at least one measurement, preferably a change with respect to the at least one object and/or the environment of the at least one object.

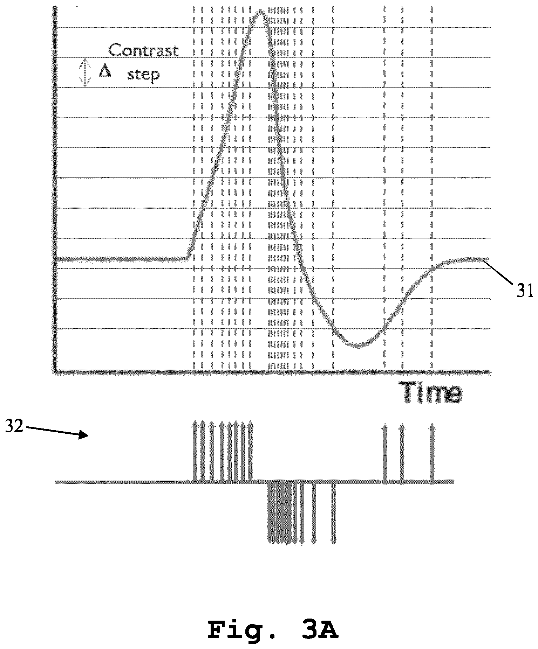

Now, with respect to Fig. 3A, an exemplary sensor signal 31 in the context of event encoding 32 is shown. The event encoding 32 is implemented with an event-based analog-to-digital converter (ADC), for instance, a level-crossing ADC which produces a positive event when crossing one contrast step or quantization step, respectively, with rising slope, and a negative event with falling slope (or vice versa).

It is noted that the respective ADC output comprises a 2-bit ternary format (i.e., +1, 0 and -1), which may especially be comprised by an event, preferably by a bipolar event. This event-based sampling approach only samples the signal when there are activities from the corresponding sensor output. Advantageously, this can significantly reduce the computation task for respective following stages, while preserving important waveform features, in the density and polarity of the events. Further advantageously, when the sensing signals need to be streamed out, the transmission energy of such an event-based transmission are also significantly reduced.

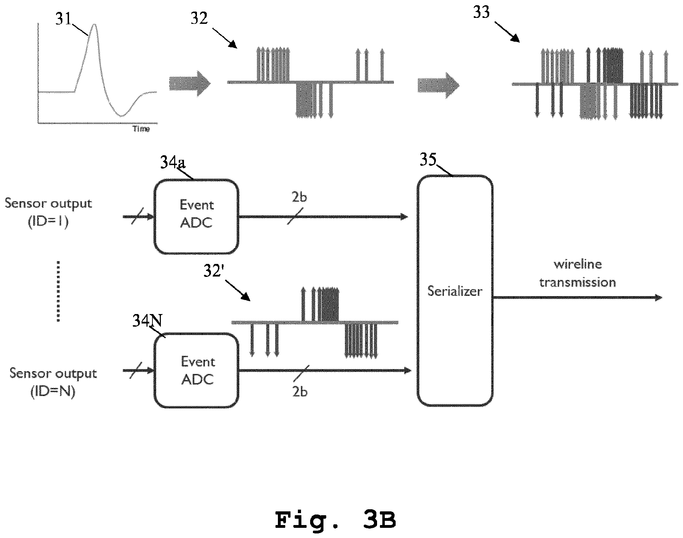

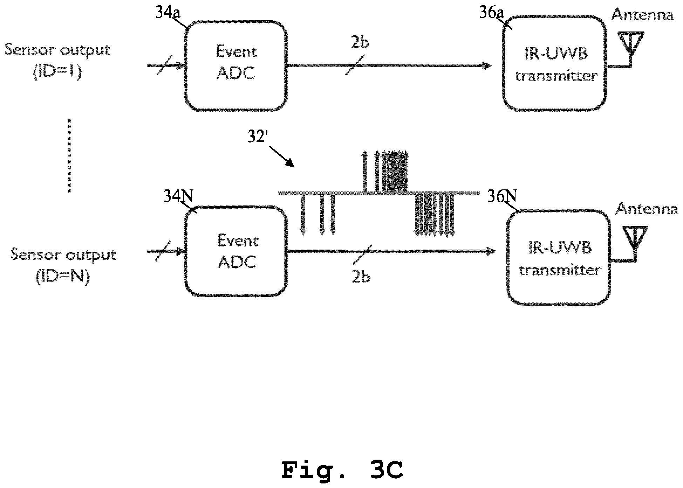

As a further advantage, such an event-based transmission can be applied to a sensor network with multiple sensor units. In this network, transmitting asynchronous events from multiple sensors may especially require serialization in the case of a wireline or wired communication (see Fig. 3B) or time-multiplexing in the medium in the case of a wireless communication (see Fig. 3C).

In accordance with Fig. 3B, there may be at least two sensors or at least two sensor outputs, respectively. Exemplarily, there are N sensors or N sensor outputs, respectively. Each of said N sensors may be connected to a corresponding event-based ADC 34a, ..., 34N. In addition to this, said N event-based ADCs 34a, ..., 34N are connected to a serializer 35.

As it can further be seen from Fig. 3B, the first sensor output exemplarily comprises the sensor signal 31 being provided for the first event-based ADC 34a. Said first event-based ADC 34a exemplarily converts said sensor signal 31 to the event encoded signal 32. By analogy therewith, the N-th event-based ADC 34N exemplarily converts the corresponding sensor signal of the N-th sensor output to a further event encoded signal 32'.

Furthermore, the serializer 35 exemplarily forms a serialized event encoded signal 33 on the basis of the event encoded signal 32 and the further event encoded signal 32' especially for the subsequent wired communication or transmission, respectively. In contrast to Fig. 3B, especially in the case of a wireless communication or transmission, respectively, the serializer 35 may be replaced by N wireless transmitters, exemplarily N IR-UWB transmitters 36a, ..., 36N as illustrated by Fig. 3C.

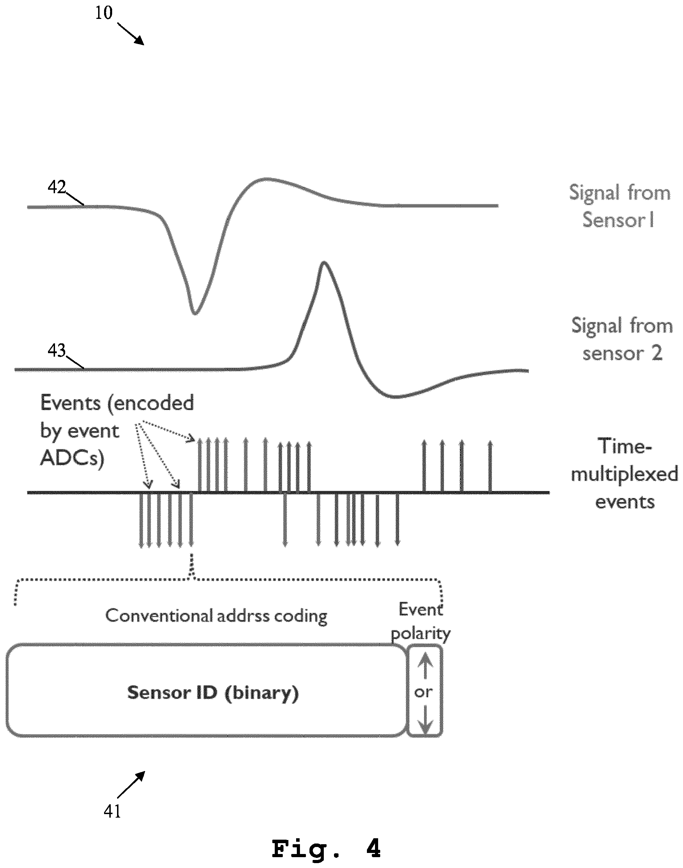

Moreover, Fig. 4 depicts an exemplary embodiment of an events transmission from two sensors in the context of a conventional address-event representation (AER) or a conventional address-event representation format 41, respectively. In this context, when transmitting asynchronous events from multiple sensor units, exemplarily two sensor units illustrated by the two sensor signals 42, 43 such system has limited capacity to upscale the number of sensor units, due to the high collision risk and protocol overhead.

Furthermore, streaming asynchronous events from multiple sensors requires to include its original sensor identifier (ID), such that the receiver has the information about where (or which sensor) these events come from. The binary ID of the sensors (i.e., the address) will be attached along with each event as shown by the AER format 41. An extra event polarity bit also needs to be included for the ternary data, to indicate it is +1 or -1.

It is to be pointed out that this conventional approach according to Fig. 4 has several problems, which are exemplarily addressed below. It is further to be pointed out that all these problems can be overcome with the aid of the invention.

Disadvantageously, in accordance with the conventional AER, there are a high energy overhead and an increased collision risk. In this context, the conventional AER introduces large overhead in active time, which makes the transmission inefficient because the sensor IDs need to be transmitted every time with the data. It is also not reliable because longer active time leads to a higher chance of collision. For instance, 128 channels need a 7-bit address on top of a 1-bit event polarity, so this already introduces 87% of transmission energy overhead and an eight times higher probability of collision.

Further disadvantageously, according to the conventional AER, there is a low-frequency signal leakage. When the serialized signal is directly transmitted, as exemplarily shown in Fig. 3B, a low-frequency content will also be produced along the communication channel.

This will introduce interference between different units. Furthermore, as an exemplary use case, if the communication channel is leaked to the human body in an in-body communication scenario, it will violate the safety regulation. In this context, for instance, IEC-60601 specifies that the low-frequency electrical leakage current should be lower than an acceptable and safe level, as low as 10 microamperes below one kilohertz.

As a further disadvantage, according to the conventional AER or a conventional modulation, respectively, there is a wireless modulation overhead. In this context, IR-UWB (especially without modification and/or not used in the context of the invention) may be applied as the wireless communication approach for such event-based system to preserve its time information. Furthermore, a pulse-position modulation (PPM) may be used for IR-UWB because of its energy-efficient implementation. However, a PPM symbol requires an about four times longer period (especially including guard intervals).

Although a binary phase shift keying (BPSK) impulse modulation can time-efficiently deliver information in one pulse period, it will not be feasible in the targeted event-based wireless sensor network. This is because that one IR-UWB receiver will receive signals from multiple transmitters sending signals simultaneously and asynchronously. It will be difficult for the receiver to recover carrier frequencies if two events are too close in time.

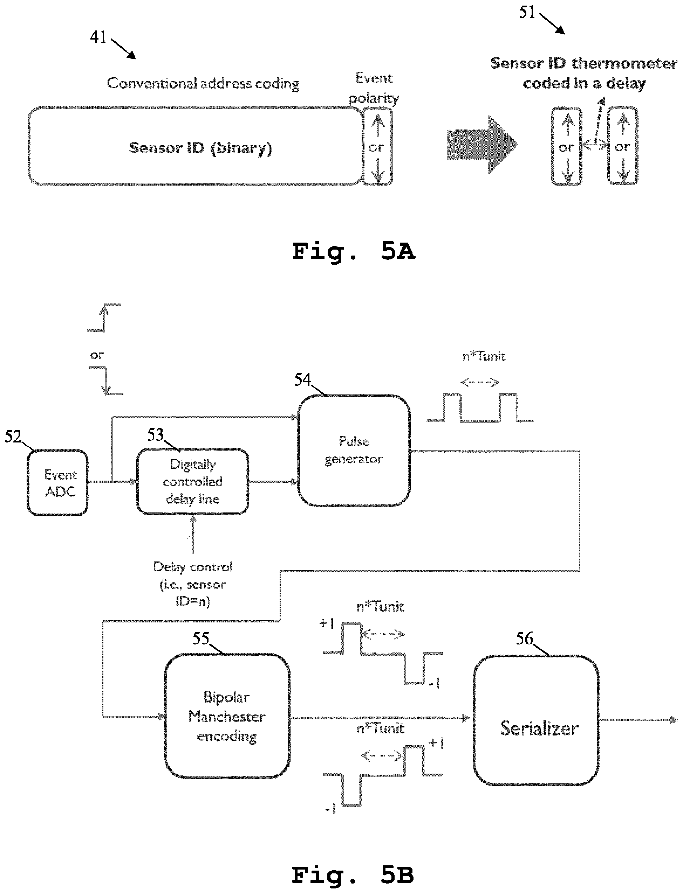

To minimize the overhead and collision risk, the active time of each event should be minimized. In contrast to the above-mentioned conventional AER format 41, an exemplary embodiment of an inventive AER format or a time-delay address-event representation (TD-AER) format 51, respectively, especially in a differential pulse format, is illustrated by Fig. 5A. In this context, a sensor ID, exemplarily the ID of a temperature sensor or a thermometer, is coded as a delay especially between two differential pulses.

More specifically, each event is converted to a pulse pair (preferably one start and one stop pulse), or a differential pulse. Then the ID of the sensor is represented by a delay between this differential pulse. For instance, sensor 1 (ID = 1) may have a delay between two pulses of 1*Tunit, while sensor 4 (ID = 4) may have a delay of 4*Tunit. Generally, the N-th sensor or sensing unit may comprise a delay of N*Tunit.

Fig. 5B shows one example of how the differential pulses can be produced using a digitally controlled delay line 53 and a pulse generator 54. Thanks to the high switching speed of modern nanoscale complementary metal-oxide-semiconductor (CMOS) transistors, the time resolution of the digitally controlled delay line 53 can achieve down to picosecond range. Hence, IDs of up to hundreds of sensor units can be coded in just few nanoseconds.

In other words, said Fig. 5B illustrates an exemplary embodiment of the inventive event-driven transmission device especially in the context of a wired transmission or communication, respectively. In this context, an output of an event-based ADC 52 is connected to an input of said digitally controlled delay line 53 and an input of said pulse generator 54, whereas an output of the delay line 53 is connected to a further input of the pulse generator 54. Furthermore, an output of the pulse generator 54 is connected to an input of a serializer 56 especially via a bipolar Manchester encoding unit 55.

It is noted that the respective differential pulse format also helps to suppress low-frequency content. Especially Manchester encoding helps to minimize the low-frequency content, which advantageously increases the galvanic isolation between the transmitter and the receiver. In such encoding, data 1 is especially converted to 01, and data 0 is especially converted to 10 (or vice versa). This Manchester encoding can be easily employed in the inventive differential pulse format.

With special respect to Fig. 5B, bipolar Manchester encoding is preferably applied to suppress low-frequency content of the signal, wherein the positive event {+1} is especially encoded as {+1, 0, -1}, while the negative event is especially encoded as {-1, 0, +1} or vice versa.

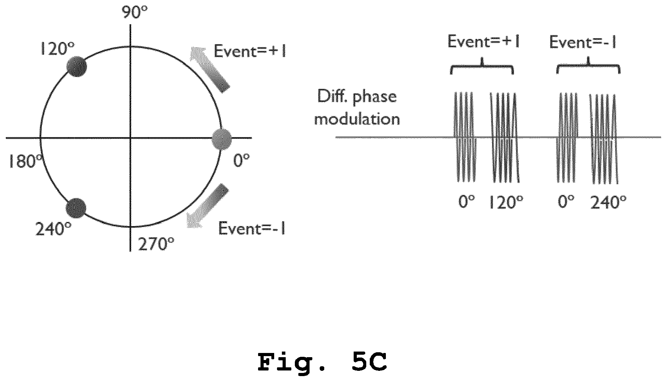

When applying this signal format in wireless transmission using IR-UWB, the inventive differential pulse format can further utilize a differential phase modulation as illustrated by Fig. 5C. In this context, the event polarity especially is in the direction of phase rotation, instead of the absolute phase, so the receiver can advantageously demodulate the signal without recovering the carrier frequency. In accordance with Fig. 5C, a differential three-phase modulation is exemplarily shown, i.e., rotating between 0°, 120° and 240° phases.

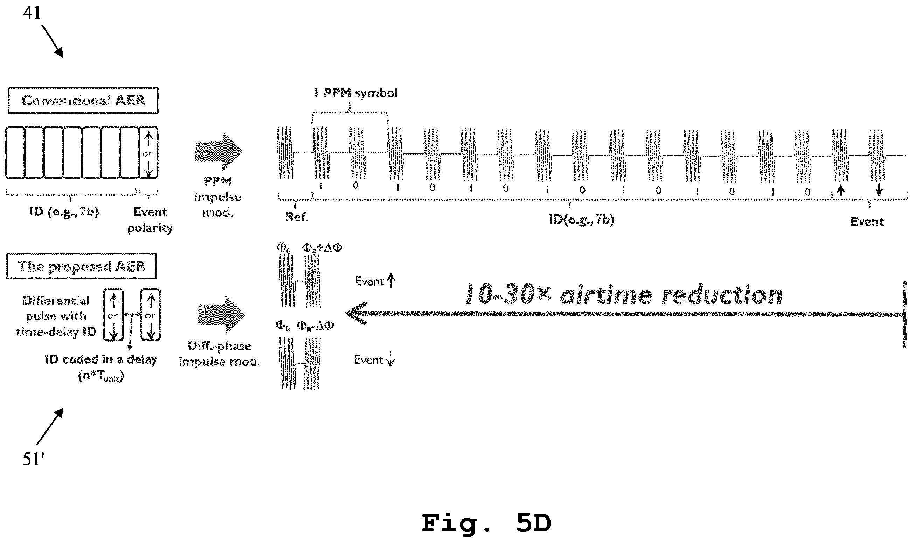

This advantageously requires only three phases from the transmitter side in accordance with Fig. 5D showing an exemplary comparison between the conventional address-event representation 41 and an embodiment of the inventive address-event representation 51', while having a higher immunity toward carrier offset on the receiver side. When combining the inventive time-delay address-event format and the differential phase modulation, the active time of event can be reduced by 10 to 30 times as exemplarily illustrated by Fig. 5D.

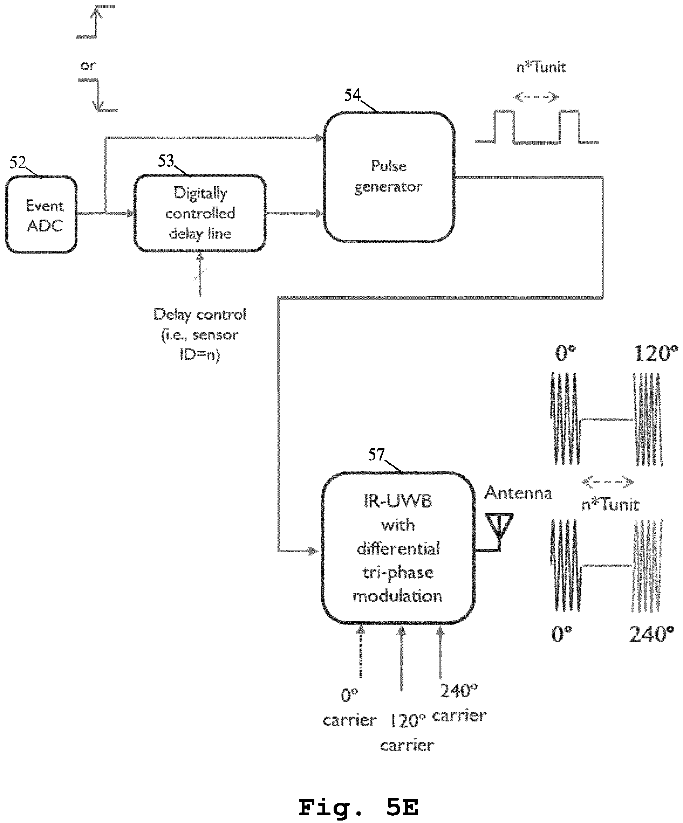

Furthermore, in accordance with Fig. 5B and 5E, two examples of implementing the inventive event-based transmission in multi-sensor scenarios especially with differential pulse format are shown. In contrast to Fig. 5B having already been described above especially in the context of a wired transmission or communication, respectively, Fig. 5E shows an exemplary embodiment in the context of a wireless transmission or communication, respectively. According to Fig. 5E, the bipolar Manchester encoding unit 55 and the serializer 56 of Fig. 5B have exemplarily been replaced by a unit 57 for applying IR-UWB with the above-mentioned differential tri-phase modulation.

Again, with respect to the conventional AER and the inventive AER, it is to be pointed out that the inventive event-based transmission especially using differential pulse format allows for solving the following issues in the conventional event-based transmission as partly noted above:
Advantageously, the respective transmission energy overhead especially for adding sensor IDs can be minimized.

Further advantageously, by leveraging the respective fine time resolution, the respective active time of events is reduced, which minimizes the risk of collisions.

As a further advantage, the inventive differential pulse format is better compatible with bipolar Manchester coding, which minimizes the low-frequency signal content. This is especially critical to minimize the interference between channels as well as the leakage in certain applications.

As an additional advantage, the inventive differential pulse format is easier to adopt differential phase modulation, which relaxes the respective carrier frequency synchronization.

Furthermore, it is generally noted that the invention may preferably be used in the context of a transmission, especially an event-based pulse transmission, from multiple users and/or sensing units. Additionally or alternatively, the invention may especially be used to support simultaneously transmitting of a large number of sensing units.

Now, as already noted above, Fig. 6 depicts an exemplary usage scenario with respect to the invention. More specifically, the invention is used in the context of intracortical neural recording with high-density multi-electrode arrays (MEA) 67. For instance, silicon-based MEAs may comprise up to 394 recording channels. They are used to record the action potential of neurons. In each recording channel, the action potential signals will be digitized by an ADC, especially sampled by clock with a fixed frequency, yielding large amount of data. This situation is even worse when distributed neural recording with MEA implanted at multiple regions of the cortex 66.

Especially when the number of channels of each MEA or the number of distributed MEAs increase, the inventive AER ensures a particularly high efficiency with respect to the transmission to the exemplary hub 68. Advantageously, the inventive AER especially based on time-delay can drastically reduce the airtime, preferably by leveraging the fast transistor switching in the modern nanoscale CMOS technologies. For the sake of completeness, it is noted that Fig. 6 further shows the scalp 61, fat 62, skull 63, dura 64, and cerebrospinal fluid 65.

Finally, with respect to Fig. 7, as already noted above, a further exemplary usage scenario is illustrated. In this context, the invention is used to collect the data from multiple event-drive radars 71a, 71b or neuromorphic cameras 72a, 72b for occupancy sensing in smart building applications.

For instance, a battery-powered radar may achieve an extremely low power consumption, which extents battery life up to years. Since it consumes very low power, it can be used to continuously monitor the occupancy of the space. If any human activities are detected by this radar such as the radars 71a, 71b, it will then activate other devices to perform other functions that requires higher processing power. Similar to the neuromorphic cameras such as the cameras 72a, 72b, the event encoding as described above can be adopted, to minimize the computation power consumption in these radars.

These event-driven radars 71a, 71b and neuromorphic cameras 72a, 72b are distributed at different locations of a building 70, especially a smart building. Furthermore, these event-driven radars 71a, 71b and neuromorphic cameras 72a, 72b send the respective encoded asynchronous events to a central hub 73, preferably wirelessly, for further processing.

It is further noted that conventional wireless communication protocols such as WiFi are not suitable because of an inefficient hardware for converting data between asynchronous and synchronous format. Advantageously, in this use case, the invention especially serves as a wireless communication protocol.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defined in accordance with the following claims.

Although the invention has been illustrated and described with respect to one or more implementations, alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. An event-driven transmission method comprising the steps of:
converting at least one event to at least one corresponding pulse pair, and
transmitting the at least one pulse pair,
wherein a delay between each pulse pair represents a corresponding identifier with respect to the respective event or with respect to at least one corresponding object causing or experiencing the respective event,
wherein the at least one object comprises or is at least one sensing unit and/or at least one sensor and/or at least one multi-electrode array (67), and
the method being **characterized in that**, with respect to the corresponding sensor signal, event encoding is implemented with an event-based analog-to-digital converter with an output comprising a 2-bit ternary format.

2. The event-driven transmission method according to claim 1,
wherein the at least one pulse pair comprises or is at least one differential pulse.

3. The event-driven transmission method according to claim 1 or 2,
wherein for transmitting the at least one pulse pair, the at least one pulse pair is encoded according to a Manchester code, preferably a bipolar Manchester code.

4. The event-driven transmission method according to claim 1 or 2,
wherein for transmitting the at least one pulse pair, the at least one pulse pair is encoded according to a phase modulation, preferably a differential phase modulation.

5. The event-driven transmission method according to claim 4,
wherein the phase modulation comprises rotating between at least two predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees.

6. The event-driven transmission method according to claim 4 or 5,
wherein transmitting the at least one pulse pair is based on an impulse-radio ultra-wideband communication, preferably an asynchronous impulse-radio ultra-wideband communication.

7. The event-driven transmission method according to any of the claims 1 to 6,
wherein the at least one object comprises or is at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar (71a, 71b) and/or at least one neuromorphic camera (72a, 72b) in the context of occupancy sensing especially with respect to smart building (70) applications.

8. The event-driven transmission method according to any of the claims 1 to 7,
wherein the at least one event comprises or is a change especially in the context of at least one measurement, preferably a change with respect to the at least one object and/or the environment of the at least one object.

9. An event-driven transmission device (10) comprising:
a transmitting unit (11) configured to convert at least one event to at least one corresponding pulse pair and to transmit the at least one pulse pair,
wherein a delay between each pulse pair represents a corresponding identifier with respect to the respective event or with respect to at least one corresponding object causing or experiencing the respective event,
wherein the at least one object comprises or is at least one sensing unit and/or at least one sensor and/or at least one multi-electrode array (67), and
the device being **characterized by** further comprising an event-based analog-to-digital converter with an output comprising a 2-bit ternary format and configured to implement event encoding with respect to the corresponding sensor signal.

10. The event-driven transmission device (10) according to claim 9,
wherein the at least one pulse pair comprises or is at least one differential pulse.

11. The event-driven transmission device (10) according to claim 9 or 10,
wherein for transmitting the at least one pulse pair, the transmitting unit (11) is configured to encode the at least one pulse pair according to a Manchester code, preferably a bipolar Manchester code.

12. The event-driven transmission device (10) according to claim 9 or 10,
wherein for transmitting the at least one pulse pair, the transmitting unit (11) is configured to encode the at least one pulse pair according to a phase modulation, preferably a differential phase modulation.

13. The event-driven transmission device (10) according to claim 12,
wherein the phase modulation comprises rotating between at least two predefined phases, preferably between at least three predefined phases with at least one predefined phase difference with regard to each other, more preferably between three predefined phases with a phase difference of 120 degrees with regard to each other, most preferably between phases of 0 degrees, 120 degrees, and 240 degrees.

14. The event-driven transmission device (10) according to claim 12 or 13,
wherein transmitting the at least one pulse pair is based on an impulse-radio ultra-wideband communication, preferably an asynchronous impulse-radio ultra-wideband communication.

15. The event-driven transmission device (10) according to any of the claims 9 to 14,
wherein the at least one object comprises or is at least one radar and/or at least one camera, preferably at least one event-driven radar and/or at least one neuromorphic camera, more preferably at least one event-driven radar and/or at least one neuromorphic camera in the context of smart building applications, most preferably at least one event-driven radar (71a, 71b) and/or at least one neuromorphic camera (72a, 72b) in the context of occupancy sensing especially with respect to smart building (70) applications.

## Patentansprüche

1. Ein ereignisgesteuertes Übertragungsverfahren, das die folgenden Schritte aufweist:
Umwandlung mindestens eines Ereignisses in mindestens ein entsprechendes Impulspaar, und
Übertragen des mindestens einen Impulspaares,
wobei eine Verzögerung zwischen jedem Impulspaar eine entsprechende Kennung in Bezug auf das jeweilige Ereignis oder in Bezug auf mindestens ein entsprechendes Objekt, das das jeweilige Ereignis verursacht oder erfährt, darstellt,
wobei das mindestens eine Objekt mindestens eine Erfassungseinheit und/oder mindestens einen Sensor und/oder mindestens ein Multielektroden-Array (67) aufweist oder ist, und das Verfahren **dadurch gekennzeichnet ist, dass** in Bezug auf das entsprechende Sensorsignal eine Ereigniskodierung mit einem ereignisbasierten Analog-Digital-Wandler mit einem Ausgang, der ein ternäres 2-Bit-Format aufweist, implementiert wird.

2. Das ereignisgesteuerte Übertragungsverfahren nach Anspruch 1,
wobei das mindestens eine Impulspaar mindestens einen Differenzimpuls aufweist oder ein solcher ist.

3. Das ereignisgesteuerte Übertragungsverfahren nach Anspruch 1 oder 2,
wobei zur Übertragung des mindestens einen Impulspaares das mindestens eine Impulspaar gemäß einem Manchester-Code, vorzugsweise einem bipolaren Manchester-Code, kodiert wird.

4. Das ereignisgesteuerte Übertragungsverfahren nach Anspruch 1 oder 2,
wobei zur Übertragung des mindestens einen Impulspaares das mindestens eine Impulspaar gemäß einer Phasenmodulation, vorzugsweise einer differentiellen Phasenmodulation, kodiert wird.

5. Das ereignisgesteuerte Übertragungsverfahren nach Anspruch 4,
wobei die Phasenmodulation ein Rotieren zwischen mindestens zwei vordefinierten Phasen, vorzugsweise zwischen mindestens drei vordefinierten Phasen mit mindestens einer vordefinierten Phasendifferenz zueinander, besonders bevorzugt zwischen drei vordefinierten Phasen mit einer Phasendifferenz von 120 Grad zueinander, besonders bevorzugt zwischen Phasen von 0 Grad, 120 Grad und 240 Grad, aufweist.

6. Das ereignisgesteuerte Übertragungsverfahren nach Anspruch 4 oder 5,
wobei die Übertragung des mindestens einen Impulspaares auf einer Impulsfunk-Ultrabreitbandkommunikation, vorzugsweise einer asynchronen Impulsfunk-Ultrabreitbandkommunikation, basiert.

7. Das ereignisgesteuerte Übertragungsverfahren nach einem der Ansprüche 1 bis 6,
wobei das mindestens eine Objekt mindestens ein Radar und/oder mindestens eine Kamera aufweist oder ist, vorzugsweise mindestens ein ereignisgesteuertes Radar und/oder mindestens eine neuromorphe Kamera, besonders bevorzugt mindestens ein ereignisgesteuertes Radar und/oder mindestens eine neuromorphe Kamera im Kontext von Smart-Building-Anwendungen, ganz besonders bevorzugt mindestens ein ereignisgesteuertes Radar (71a, 71b) und/oder mindestens eine neuromorphe Kamera (72a, 72b) im Kontext von Belegungserkennung, insbesondere im Hinblick auf Smart-Building-Anwendungen (70).

8. Das ereignisgesteuerte Übertragungsverfahren nach einem der Ansprüche 1 bis 7,
wobei das mindestens eine Ereignis eine Änderung insbesondere im Rahmen mindestens einer Messung aufweist oder ist, vorzugsweise eine Änderung in Bezug auf das mindestens eine Objekt und/oder die Umgebung des mindestens einen Objekts.

9. Eine ereignisgesteuerte Übertragungsvorrichtung (10), die aufweist:
eine Übertragungseinheit (11), die dazu eingerichtet ist, mindestens ein Ereignis in mindestens ein entsprechendes Impulspaar umzuwandeln und das mindestens eine Impulspaar zu übertragen,
wobei eine Verzögerung zwischen jedem Impulspaar eine entsprechende Kennung in Bezug auf das jeweilige Ereignis oder in Bezug auf mindestens ein entsprechendes Objekt darstellt, das das jeweilige Ereignis verursacht oder erfährt,
wobei das mindestens eine Objekt mindestens eine Erfassungseinheit und/oder mindestens einen Sensor und/oder mindestens ein Multielektroden-Array (67) aufweist oder ist, und
die Vorrichtung **dadurch gekennzeichnet ist, dass** sie ferner einen ereignisbasierten Analog-Digital-Wandler mit einem Ausgang aufweist, der ein ternäres 2-Bit-Format aufweist und dazu eingerichtet ist, eine Ereigniskodierung in Bezug auf das entsprechende Sensorsignal zu implementieren.

10. Die ereignisgesteuerte Übertragungsvorrichtung (10) nach Anspruch 9,
wobei das mindestens eine Impulspaar mindestens einen Differenzimpuls aufweist oder ein solcher ist.

11. Die ereignisgesteuerte Übertragungsvorrichtung (10) nach Anspruch 9 oder 10,
wobei die Übertragungseinheit (11) zur Übertragung des mindestens einen Impulspaares dazu eingerichtet ist, das mindestens eine Impulspaar gemäß einem Manchester-Code, vorzugsweise einem bipolaren Manchester-Code, zu kodieren.

12. Die ereignisgesteuerte Übertragungsvorrichtung (10) nach Anspruch 9 oder 10,
wobei die Übertragungseinheit (11) zur Übertragung des mindestens einen Impulspaares dazu eingerichtet ist, das mindestens eine Impulspaar gemäß einer Phasenmodulation, vorzugsweise einer differentiellen Phasenmodulation, zu kodieren.

13. Die ereignisgesteuerte Übertragungsvorrichtung (10) nach Anspruch 12,
wobei die Phasenmodulation ein Rotieren zwischen mindestens zwei vordefinierten Phasen, vorzugsweise zwischen mindestens drei vordefinierten Phasen mit mindestens einer vordefinierten Phasendifferenz zueinander, besonders bevorzugt zwischen drei vordefinierten Phasen mit einer Phasendifferenz von 120 Grad zueinander, besonders bevorzugt zwischen Phasen von 0 Grad, 120 Grad und 240 Grad, aufweist.

14. Die ereignisgesteuerte Übertragungsvorrichtung (10) nach Anspruch 12 oder 13,
wobei die Übertragung des mindestens einen Impulspaares auf einer Impulsfunk-Ultrabreitbandkommunikation, vorzugsweise einer asynchronen Impulsfunk-Ultrabreitbandkommunikation, basiert.

15. Die ereignisgesteuerte Übertragungsvorrichtung (10) nach einem der Ansprüche 9 bis 14, wobei das mindestens eine Objekt mindestens ein Radar und/oder mindestens eine Kamera aufweist oder ist, vorzugsweise mindestens ein ereignisgesteuertes Radar und/oder mindestens eine neuromorphe Kamera, besonders bevorzugt mindestens ein ereignisgesteuertes Radar und/oder mindestens eine neuromorphe Kamera im Kontext von Smart-Building-Anwendungen, ganz besonders bevorzugt mindestens ein ereignisgesteuertes Radar (71a, 71b) und/oder mindestens eine neuromorphe Kamera (72a, 72b) im Kontext der Belegungserkennung, insbesondere im Hinblick auf Smart-Building-Anwendungen (70).

## Revendications

1. Un procédé de transmission commandé par événement comportant les étapes consistant à :
convertir au moins un événement en au moins une paire d'impulsions correspondante, et
transmettre la au moins une paire d'impulsions,
dans lequel un retard entre chaque paire d'impulsions représente un identifiant correspondant par rapport à l'événement respectif ou par rapport à au moins un objet correspondant entraînant ou confronté à l'événement respectif,
dans lequel le au moins un objet comporte ou est au moins une unité de détection et/ou au moins un capteur et/ou au moins un réseau d'électrodes multiples (67), et
le procédé étant **caractérisé en ce que**
par rapport au signal de capteur correspondant, un codage d'événement est mis en oeuvre avec un convertisseur analogique-numérique à base d'événement avec une sortie comportant un format ternaire de 2 bits.

2. Le procédé de transmission commandé par événement selon la revendication 1, dans lequel la au moins une paire d'impulsions comporte ou est au moins une impulsion différentielle.

3. Le procédé de transmission commandé par événement selon la revendication 1 ou 2, dans lequel pour transmettre la au moins une paire d'impulsions, la au moins une paire d'impulsions est codée selon un code Manchester, de préférence un code Manchester bipolaire.

4. Le procédé de transmission commandé par événement selon la revendication 1 ou 2, dans lequel pour transmettre la au moins une paire d'impulsions, 1 au moins une paire d'impulsions est codée selon une modulation de phase, de préférence une modulation de phase différentielle.

5. Le procédé de transmission commandé par événement selon la revendication 4, dans lequel la modulation de phase comporte une rotation entre au moins deux phases prédéfinies, de manière préféré entre au moins trois phases prédéfinies avec au moins un déphasage mutuel prédéfini, de manière plus préférée entre trois phases prédéfinies avec un déphasage mutuel de 120 degrés, de manière la plus préférée entre des phases de 0 degré, 120 degrés et 240 degrés.

6. Le procédé de transmission commandé par événement selon la revendication 4 ou 5, dans lequel la transmission de la au moins une paire d'impulsions est basée sur une radiocommunication d'impulsions à bande ultra large, de préférence une radiocommunication d'impulsions à bande ultra large asynchrone.

7. Le procédé de transmission commandé par événement selon l'une quelconque des revendications 1 à 6,
dans lequel le au moins un objet comporte ou est au moins un radar et/ou au moins une caméra, de manière préférée au moins un radar commandé par événement et/ou au moins une caméra neuromorphique, de manière plus préférée au moins un radar commandé par événement et/ou au moins une caméra neuromorphique dans le contexte d'applications de bâtiment intelligent, de manière la plus préférée au moins un radar commandé par événement (71a, 71b) et/ou au moins une caméra neuromorphique (72a, 72b) dans le contexte de la détection d'occupation en particulier en ce qui concerne des applications de bâtiment intelligent (70).

8. Le procédé de transmission commandé par événement selon l'une quelconque des revendications 1 à 7,
dans lequel le au moins un événement comporte ou est un changement en particulier dans le contexte d'au moins une mesure, de préférence un changement par rapport au au moins un objet et/ou à l'environnement du au moins un objet.

9. Un dispositif de transmission commandé par événement (10) comportant :
une unité de transmission (11) configurée pour convertir au moins un événement en au moins une paire d'impulsions correspondante et pour transmettre la au moins une paire d'impulsions,
dans lequel un retard entre chaque paire d'impulsions représente un identifiant correspondant par rapport à l'événement respectif ou par rapport à au moins un objet correspondant entraînant ou confronté à l'événement respectif,
dans lequel le au moins un objet comporte ou est au moins une unité de détection et/ou au moins un capteur et/ou au moins un réseau d'électrodes multiples (67), et
le dispositif étant **caractérisé en ce qu'**il comporte en outre un convertisseur analogique-analogique à base d'événement avec une sortie comportant un format ternaire de 2 bits et configuré pour mettre en oeuvre un codage d'événement par rapport au signal de capteur correspondant.

10. Le dispositif de transmission commandé par événement (10) selon la revendication 9,
dans lequel la au moins une paire d'impulsions comporte ou est au moins une impulsion différentielle.

11. Le dispositif de transmission commandé par événement (10) selon la revendication 9 ou 10,
dans lequel pour transmettre la au moins une paire d'impulsions, l'unité de transmission (11) est configurée pour coder la au moins une paire d'impulsions selon un code Manchester, de préférence un code Manchester bipolaire.

12. Le dispositif de transmission commandé par événement (10) selon la revendication 9 ou 10,
dans lequel pour transmettre la au moins une paire d'impulsions, l'unité de transmission (11) est configurée pour coder la au moins une paire d'impulsions selon une modulation de phase, de préférence une modulation de phase différentielle.

13. Le dispositif de transmission commandé par événement (10) selon la revendication 12,
dans lequel la modulation de phase comporte une rotation entre au moins deux phases prédéfinies, de manière préférée entre au moins trois phases prédéfinies avec au moins un déphasage mutuel prédéfini, de manière plus préférée entre trois phases prédéfinies avec un déphasage mutuel de 120 degrés, de manière la plus préférée entre des phases de 0 degré, 120 degrés et 240 degrés.

14. Le dispositif de transmission commandé par événement (10) selon la revendication 12 ou 13,
dans lequel la transmission de la au moins une paire d'impulsions est basée sur une radiocommunication d'impulsions à bande ultra large, de préférence une radiocommunication d'impulsions à bande ultra large asynchrone.

15. Le dispositif de transmission commandé par événement (10) selon l'une quelconque des revendications 9 à 14,
dans lequel le au moins un objet comporte ou est au moins un radar et/ou au moins une caméra, de manière préférée au moins un radar commandé par événement et/ou au moins une caméra neuromorphique, de manière plus préférée au moins un radar commandé par événement et/ou au moins une caméra neuromorphique dans le contexte d'applications de bâtiment intelligent, de manière la plus préférée au moins un radar commandé par événement (71a, 71b) et/ou au moins une caméra neuromorphique (72a, 72b) dans le contexte de la détection d'occupation en particulier en ce qui concerne des applications de bâtiment intelligent (70).
